# EUROPEAN PATENT APPLICATION

(11) **EP 3 367 443 A1**
(43) Date of publication of application: **29.08.2018**
(21) Application number: 18157161.3
(22) Date of filing: 16.02.2018
(51) Int. Cl.: H01L 29/78, H01L 29/06, H01L 29/12

(54) **METAL-OXIDE-SEMICONDUCTOR FIELD-EFFECT TRANSISTOR**

(30) Priority: 27.02.2017 JP 2017034853
(71) Applicant: Toyota Jidosha Kabushiki Kaisha, Aichi-Ken 471-8571 (JP)
(72) Inventor: ARAUCHI, Takuji, TOYOTA-SHI, AICHI-KEN, 471-8571 (JP); KINPARA, Hiromichi, TOYOTA-SHI, AICHI-KEN, 471-8571 (JP); TSUJIMURA, Masatoshi, TOYOTA-SHI, AICHI-KEN, 471-8571 (JP); YAMASHITA, Yusuke, NAGAKUTE-SHI, AICHI-KEN, 480-1192 (JP); URAKAMI, Yasushi, KARIYA-CITY, AICHI-PREF, 448-8661 (JP)
(74) Representative: Cabinet Beau de Loménie

(57) **Abstract**

A silicon carbide trench gate MOSFET device comprising a region (42) includes a high-concentration region (42a) and a low-concentration region (42b) that are arranged along a thickness direction of a silicon carbide substrate. A concentration of a p-type dopant in the low-concentration region (42b) is lower than a concentration of the p-type dopant in the high-concentration region (42a). The high-concentration region (42a) contacts the low-concentration region (42b), and is disposed between a bottom surface (13b) of a gate trench (13) and the low-concentration region (42b). In graph obtained by plotting the concentration of the p-type dopant in the floating region (42) along the thickness direction, a bending point or an inflection point appears on a boundary between the high-concentration region (42a) and the low-concentration region (42b). A content of the p-type dopant in the low-concentration region (42b) is equal to or higher than a content of an n-type dopant in a portion of the drift region (34), which is adjacent to the low-concentration region (42b) in the thickness direction.

## Description

### BACKGROUND OF THE INVENTION

### 1. Field of the Invention

The invention relates to a metal-oxide-semiconductor field-effect transistor.

### 2. Description of Related Art

There is a metal-oxide-semiconductor field-effect transistor (MOSFET) having a structure in which a p-type floating region is disposed within an n-type drift region. The floating region is disposed adjacent to a bottom surface of a trench. The floating region is connected to a body region via, for example, a p-type connection region extending along an end surface of the trench. With this structure, depletion of the drift region is promoted so that the withstand voltage of a semiconductor device can be increased. In general, a floating region is formed by ion implantation of a p-type dopant through an inner surface of a trench. Japanese Unexamined Patent Application Publication No. 2005-116822 describes a MOSFET including a floating region, and a method of producing the MOSFET.

### SUMMARY OF THE INVENTION

It is required that a floating region should contain a certain amount of p-type dopant depending on an amount of n-type dopant contained in a drift region. If the content of the p-type dopant in the floating region is insufficient with respect to the content of the n-type dopant in the drift region, the drift region cannot be sufficiently depleted. Further, in order to connect the floating region to a body region with low resistance, it is required that at least a part of the floating region should contain the p-type dopant at a relatively high concentration. In order to satisfy these requirements, the implantation concentration of the p-type dopant may be set to a relatively high value, in the ion implantation performed to form a floating region.

However, if the implantation concentration of the p-type dopant is increased, a non-negligible number of crystal defects (lattice defects) occur when the implantation concentration exceeds a certain value. Such crystal defects in a semiconductor substrate may be a leakage source that induces leakage currents, resulting in a decrease in the withstand voltage of the semiconductor device. As described above, there is a trade-off relationship between the content and the concentration of the p-type dopant in the floating region, and a technique for addressing this issue has been demanded. In particular, in a trench gate MOSFET including a silicon carbide (SiC) semiconductor substrate (hereinafter, referred to as "SiC substrate" where appropriate), a relatively thin drift region is provided in many cases by taking advantage of a wide bandgap characteristic of SiC. As a result, the strength of an electric field generated in the drift region is easily increased. Therefore, even crystal defects that can be ignored in, for example, a silicon substrate cannot be ignored in a SiC substrate.

In the light of the above-described circumstances, the invention provides a technique for achieving an appropriate concentration profile of a p-type dopant in a floating region in a trench gate MOSFET including a SiC substrate.

An aspect of the invention provides a MOSFET. The MOSFET according to the aspect of the invention includes a SiC substrate including a trench; and a gate electrode disposed in the trench. The SiC substrate includes: an n-type source region; an n-type drift region; a p-type body region disposed between the n-type source region and the n-type drift region; a p-type floating region disposed within the drift region, the p-type floating region being adjacent to a bottom surface of the trench; and a p-type connection region extending from the p-type body region to the p-type floating region. The p-type floating region includes a high-concentration region and a low-concentration region that are arranged along a thickness direction of the SiC substrate, the high-concentration region is disposed between the bottom surface of the trench and the low-concentration region, the high-concentration region being in contact with the low-concentration region, when a graph is obtained by plotting a concentration of a p-type dopant in the p-type floating region along the thickness direction, a maximum concentration of the p-type dopant is higher in the high-concentration region than in the low-concentration region, and the graph has a bending point or an inflection point on a boundary between the high-concentration region and the low-concentration region, and a content of the p-type dopant in the low-concentration region is equal to or higher than a content of an n-type dopant in a portion of the n-type drift region, the portion being adjacent to the low-concentration region in the thickness direction.

With the foregoing structure, the concentration of the p-type dopant in the floating region is higher in the high-concentration region that is close to the bottom surface of the trench, than in the low-concentration region that is apart from the bottom surface of the trench. As described above, the content of the p-type dopant in the low-concentration region is equal to or higher than the content of an n-type dopant in the portion of the drift region, which is adjacent to the low-concentration region. That is, the low-concentration region contains the p-type dopant in such an amount that the drift region can be sufficiently depleted. Therefore, even if the low-concentration region is depleted through pn junction between the drift region and the floating region, the high-concentration region is prevented from being completely depleted. Thus, a strong electric field is not generated in the high-concentration region. Hence, even if a relatively large number of crystal defects are present in the high-concentration region, the withstand voltage of the semiconductor device is maintained. Therefore, in the ion implantation performed to form the high-concentration region, the implantation concentration of the p-type dopant may be set relatively high so that the floating region is connected to the body region with low resistance. On the other hand, a relatively strong electric field may be generated in the low-concentration region due to the depletion through the pn junction with the drift region. In the low-concentration region, however, the implantation concentration of the p-type dopant in the ion implantation is low, and hence, the occurrence of crystal defects is suppressed. Therefore, even if a relatively strong electric field is generated in the low-concentration region, the withstand voltage of the semiconductor device is maintained.

In view of connecting the floating region to the body region with low resistance, a higher priority is given to the maximum concentration of the p-type dopant than to the content of the p-type dopant. Therefore, the concentration profile of the p-type dopant in the high-concentration region may have a relatively steep peak. On the other hand, in view of sufficiently depleting the drift region, a higher priority is given to the content of the p-type dopant than to the maximum concentration of the p-type dopant. Therefore, the concentration profile of the p-type dopant in the low-concentration region may have a relatively flat shape within the range where the occurrence of crystal defects is suppressed. Based on the foregoing knowledge, in the graph obtained by plotting, in the thickness direction, the concentration of the p-type dopant in the floating region, a bending point or an inflection point may appear on the boundary between the high-concentration region and the low-concentration region.

In the above aspect, where NA represents the maximum concentration of the p-type dopant in the high-concentration region and NB represents the maximum concentration of the p-type dopant in the low-concentration region, a condition of NA/NB ≥ 2.5 may be satisfied. In other words, the maximum concentration NB of the p-type dopant in the low-concentration region may be at most 40% of the maximum concentration NA of the p-type dopant in the high-concentration region.

With this structure, there is a sufficiently large difference in the concentration of the p-type dopant between the high-concentration region and the low-concentration region. Therefore, occurrence of crystal defects in the low-concentration region is suppressed, and the electric resistance in the high-concentration region is sufficiently reduced.

In the above aspect, the boundary between the high-concentration region and the low-concentration region may be apart, in the thickness direction, from the bottom surface of the trench by a first distance; a boundary between the low-concentration region and the n-type drift region may be apart, in the thickness direction, from the bottom surface of the trench by a second distance; and where XA represents the first distance and XB represents the second distance, a condition of XB/XA ≥ 2 may be satisfied. This means that the high-concentration region may be disposed within a half portion of the floating region, which is on the trench side.

With this structure, the low-concentration region is relatively wide, so that the maximum concentration of the p-type dopant in the low-concentration region is reduced. Therefore, occurrence of crystal defects in the low-concentration region is further effectively suppressed.

In the above aspect, the low-concentration region may include a flat region and a reduction region that are arranged along the thickness direction of the silicon carbide substrate. The flat region may be a region that is in contact with the high-concentration region, and in which a concentration of the p-type dopant is within a prescribed range with respect to a concentration of the p-type dopant at the bending point or the inflection point; and the reduction region may be a region that is in contact with the n-type drift region, and in which the concentration of the p-type dopant decreases in a direction away from the bottom surface of the trench.

### BRIEF DESCRIPTION OF THE DRAWINGS

Features, advantages, and technical and industrial significance of exemplary aspects of the invention will be described below with reference to the accompanying drawings, in which like numerals denote like elements, and wherein:
FIG. 1 is a sectional view illustrating the structure of a semiconductor device according to an embodiment, FIG. 1 being a sectional view taken along line I-I in FIG. 2;
FIG. 2 is a diagram illustrating the arrangement of trenches in an upper surface of a SiC substrate;
FIG. 3 is a sectional view illustrating the structure in the vicinity of an end surface of the trench, FIG. 3 being a sectional view taken along line III-III in FIG. 2;
FIG. 4 illustrates a concentration profile of a p-type dopant in a floating region, the concentration profile being obtained by plotting, as a graph, the concentration of the p-type dopant in the floating region along the thickness direction of the SiC substrate;
FIG. 5 is a graph illustrating a suitable numerical range (corresponding to a hatched region) of a depth ratio X and a concentration ratio N;
FIG. 6 is a diagram illustrating one step of a method of producing the semiconductor device, and illustrating the SiC substrate including a drain region, a drift region, and a body region;
FIG. 7 is a diagram illustrating another step of the method of producing the semiconductor device, and illustrating the SiC substrate in which contact regions, source regions, and trenches have been formed;
FIG. 8 is a diagram illustrating still another step of the method of producing the semiconductor device, and illustrating the SiC substrate in which floating regions have been formed by ion implantation of a p-type dopant;
FIG. 9A is a graph illustrating one specific example of the concentration profile of the p-type dopant in the floating region;
FIG. 9B is graph illustrating another specific example of the concentration profile of the p-type dopant in the floating region; and
FIG. 9C is graph illustrating still another specific example of the concentration profile of the p-type dopant in the floating region.

### DETAILED DESCRIPTION OF ASPECTS

Hereinafter, a semiconductor device 10 according to an embodiment and a method of producing the semiconductor device 10 will be described with reference to the accompanying drawings. The semiconductor device 10 in the present embodiment is a power semiconductor device used in an electric power circuit. The semiconductor device 10 particularly has a MOSFET structure. Although the usage of the semiconductor device 10 is not particularly limited, the semiconductor device 10 may be used as a switching element for an electric power converter circuit, such as a converter or an inverter, in electrically-powered vehicles, such as hybrid vehicles, fuel cell vehicles, and electric vehicles. In the following, the structure of the semiconductor device 10 will be described first, and then the method of producing the semiconductor device 10 will be described. Note that the semiconductor device 10 and the method of producing the semiconductor device 10 described below are each just one example, and technical elements described in this specification may be, individually or in various combinations, applied to various other semiconductor devices and methods of producing the same.

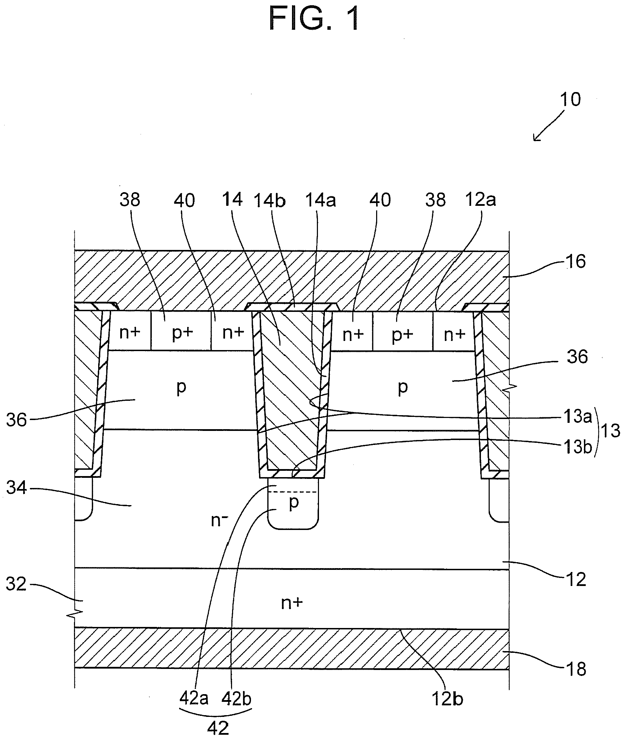

FIG. 1 is a sectional view illustrating the structure of the semiconductor device 10 according to the present embodiment. FIG. 1 is a partial sectional view of the semiconductor device 10. In the semiconductor device 10, the unit structure illustrated in FIG. 1 is repeatedly provided. As illustrated in FIG. 1, the semiconductor device 10 according to the present embodiment includes a SiC substrate 12, and a gate electrode 14 disposed in each of trenches 13 provided in an upper surface 12a of the SiC substrate 12. The gate electrode 14 is made of a conductive material, such as polysilicon.

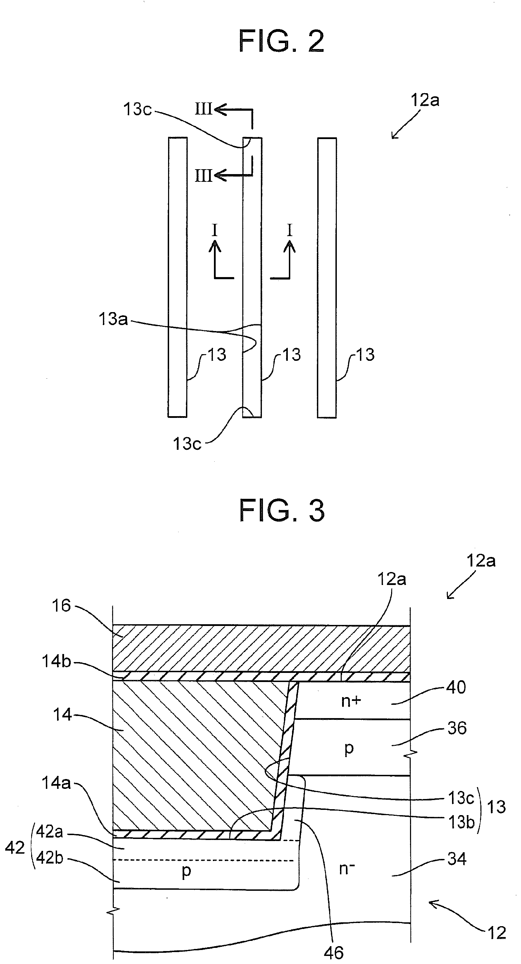

As illustrated in FIG. 1 and FIG. 2, a plurality of the trenches 13 is provided in the upper surface 12a of the SiC substrate 12. The trenches 13 extend parallel to one another. Each trench 13 has a pair of side surfaces 13a, a bottom surface 13b, and a pair of end surfaces 13c. The side surfaces 13a are inner surfaces that face each other in the width direction of the trench 13, and the end surfaces 13c are inner surfaces that face each other in the longitudinal direction of the trench 13. A gate insulating film 14a is provided in the trench 13, and the gate electrode 14 faces the SiC substrate 12 with the gate insulating film 14a interposed therebetween. The gate insulating film 14a is made of an insulating material, such as silicon oxide (SiO₂). Note that the materials of the gate electrode 14 and the gate insulating film 14a are not limited to any specific materials.

The semiconductor device 10 further includes a source electrode 16 disposed on the upper surface 12a of the SiC substrate 12, and a drain electrode 18 disposed on a lower surface 12b of the SiC substrate 12. The source electrode 16 is in ohmic contact with the upper surface 12a of the SiC substrate 12, and the drain electrode 18 is in ohmic contact with the lower surface 12b of the SiC substrate 12. An interlayer insulating film 14b is disposed between the source electrode 16 and the gate electrode 14, so that the source electrode 16 is electrically insulated from the gate electrode 14. The source electrode 16 and the drain electrode 18 may be made of a conductive material, such as aluminum (Al), nickel (Ni), titanium (Ti), or gold (Au). Note that the materials of the source electrode 16 and the drain electrode 18 are not limited to any specific materials.

In this specification, the upper surface 12a of the SiC substrate 12 means one surface of the SiC substrate 12, and the lower surface 12b of the SiC substrate 12 means another surface of the SiC substrate 12, which is on the opposite side of the SiC substrate 12 from the upper surface 12a. In this specification, the terms "upper surface" and "lower surface" are used to distinguish two opposite surfaces of the SiC substrate 12 from each other for the sake of convenience, and do not intend to mean that the upper surface 12a of the SiC substrate 12 is always positioned vertically above the lower surface 12b thereof. Depending on the posture of the SiC substrate 12, the upper surface 12a may be positioned vertically below the lower surface 12b.

The SiC substrate 12 includes a drain region 32, a drift region 34, body regions 36, contact regions 38, source regions 40, and floating regions 42. The drain region 32 is disposed along the lower surface 12b of the SiC substrate 12, and exposed at the lower surface 12b. The drain region 32 is an n-type region containing a large amount of an n-type dopant. The n-type dopant may be a group V element (a group 15 element), such as phosphorus. The drain electrode 18 is in ohmic contact with the drain region 32.

The drift region 34 is disposed on the drain region 32, and is adjacent to the drain region 32. The drift region 34 is an n-type region. The concentration of the n-type dopant in the drift region 34 is lower than the concentration of the n-type dopant in the drain region 32. The n-type dopant may be a group V element (a group 15 element), such as phosphorus. The body regions 36 are disposed on the drift region 34, and are adjacent to the drift region 34. The body regions 36 are separated from the drain region 32 by at least the drift region 34. Each body region 36 is a p-type region containing a large amount of a p-type dopant. The p-type dopant may be a group III element (a group 13 element), such as boron (B) or aluminum (Al).

The contact regions 38 are disposed on the body regions 36, and are exposed at the upper surface 12a of the SiC substrate 12. Each contact region 38 is a p-type region. The concentration of the p-type dopant in the contact regions 38 is higher than the concentration of the p-type dopant in the body regions 36. The p-type dopant may be a group III element (a group 13 element), such as boron (B) or aluminum (Al). The source regions 40 are disposed on the body regions 36, and are exposed at the upper surface 12a of the SiC substrate 12. The source regions 40 are separated from the drift region 34 by at least the body regions 36. Each source region 40 is an n-type region. The concentration of the n-type dopant in the source regions 40 is higher than the concentration of the n-type dopant in the drift region 34. The n-type dopant may be a group V element (a group 15 element), such as phosphorus. The source electrode 16 is in ohmic contact with the contact regions 38 and the source regions 40. The trenches 13 extend from the upper surface 12a of the SiC substrate 12 through the source regions 40 and the body regions 36 into the drift region 34.

Each floating region 42 is disposed within the drift region 34 so as to be adjacent to the bottom surface 13b of the corresponding trench 13. The floating region 42 is a p-type region. The concentration of the p-type dopant in each floating region 42 is, for example, substantially equal to the concentration of the p-type dopant in each body region 36, and is lower than the concentration of the p-type dopant in each contact region 38. The p-type dopant may be a group III element (a group 13 element), such as boron (B) or aluminum (Al). Although described later in detail, each floating region 42 is formed by ion implantation of the p-type dopant into an n-type region that is the same as the drift region 34. When the p-type floating regions 42 are disposed within the n-type drift region 34, depletion of the n-type drift region 34 is promoted, so that the withstand voltage of the semiconductor device 10 can be increased.

As illustrated in FIG. 3, the SiC substrate 12 further includes p-type connection regions 46. Each p-type connection region 46 extends, along the end surface 13c of the corresponding trench 13, from the body region 36 to the floating region 42. The floating region 42 is connected to the body region 36 with the connection region 46 interposed therebetween, so that the electric potential of the floating region 42 is maintained at the same level as that of the body region 36.

As illustrated in FIG. 1 and FIG. 3, each floating region 42 includes a high-concentration region 42a and a low-concentration region 42b that are arranged in the thickness direction of the SiC substrate 12. In this specification, the term "thickness direction of the SiC substrate 12" means a direction perpendicular to the upper surface 12a and the lower surface 12b of the SiC substrate 12. The thickness direction of the SiC substrate 12 coincides with the depth direction of the trench 13. The concentration of the p-type dopant in the low-concentration region 42b is lower than the concentration of the p-type dopant in the high-concentration region 42a. The high-concentration region 42a is disposed between the bottom surface 13b of the trench 13 and the low-concentration region 42b. In other words, the high-concentration region 42a is disposed close to the bottom surface 13b of the trench 13, and the low-concentration region 42b is disposed apart from the bottom surface 13b of the trench 13.

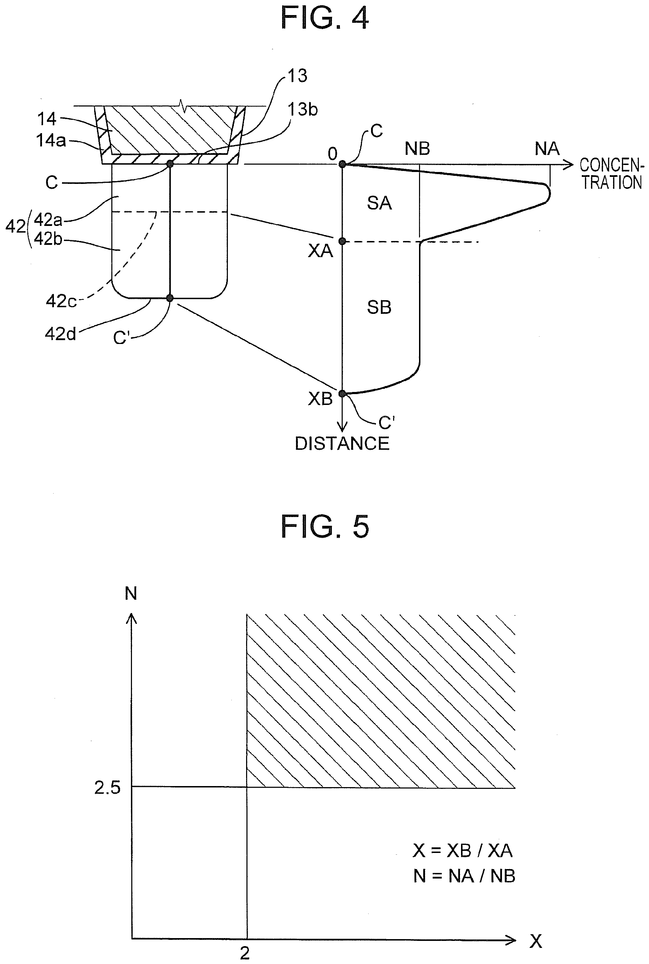

With reference to FIG. 4, the concentration profile of the p-type dopant in the floating region 42 will be described. As illustrated in FIG. 4, a boundary 42c between the high-concentration region 42a and the low-concentration region 42b is apart, in the thickness direction of the SiC substrate 12, from the bottom surface 13b of the trench 13 by a first distance XA. Further, a boundary 42d between the low-concentration region 42b and the drift region 34 is apart, in the thickness direction of the SiC substrate 12, from the bottom surface 13b of the trench 13 by a second distance XB. The boundary 42d serves also as a boundary of the floating region 42, and is a position where the concentration of the p-type dopant is equal to the concentration of the n-type dopant in the drift region 34. In other words, strictly speaking, the concentration of the p-type dopant is not zero at the boundary 42d of the floating region 42. The second distance XB is longer than the first distance XA. A point C in FIG. 4 is a point on the bottom surface 13b of the trench 13, and a point C' is a point on the boundary 42d between the low-concentration region 42b and the drift region 34. A straight line passing through the point C and the point C' is parallel to the thickness direction of the SiC substrate 12, and is positioned at the center of the trench 13 in its width direction. In the concentration profile illustrated in FIG. 4, the content SA of the p-type dopant in the high-concentration region 42a is expressed as an area labeled as SA, and the content SB of the p-type dopant in the low-concentration region 42b is expressed as an area labeled as SB.

As illustrated in FIG. 4, when the concentration of the p-type dopant in the floating region 42 is plotted along the thickness direction of the SiC substrate 12 as a graph, a bending point (i.e., a point at which the slope of a curve changes) or an inflection point (i.e., a point at which the sign of the curvature of a curve changes) appears at the boundary 42c between the high-concentration region 42a and the low-concentration region 42b in the graph. In other words, the position of the bending point or the inflection point in the graph in FIG. 4 corresponds to the position of the boundary 42c between the high-concentration region 42a and the low-concentration region 42b. The content SB of the p-type dopant in the low-concentration region 42b is equal to or higher than the content of the n-type dopant in a portion of the drift region 34, which is adjacent to the low-concentration region 42b in the thickness direction (i.e., a portion of the drift region 34, which is disposed between the low-concentration region 42b and the drain region 32). In other words, the low-concentration region 42b contains the p-type dopant in such an amount that the drift region 34 can be sufficiently depleted. Strictly speaking, it is necessary to take into account the amount of the n-type dopant in the low-concentration region 42b. However, the low-concentration region 42b is significantly smaller in size than the drift region 34, and hence the n-type dopant in the low-concentration region 42b can be ignored.

With the foregoing structure, the concentration of the p-type dopant in the floating region 42 is higher in the high-concentration region 42a that is close to the bottom surface 13b of the trench 13, than in the low-concentration region 42b that is apart from the bottom surface 13b of the trench 13. As described above, the low-concentration region 42b contains the p-type dopant in such an amount that the drift region 34 can be sufficiently depleted. Therefore, even if the low-concentration region 42b is depleted through pn junction between the drift region 34 and the floating region 42, the high-concentration region 42a is prevented from being completely depleted. Thus, a strong electric field is not generated in the high-concentration region 42a. Hence, even if a relatively large number of crystal defects are present in the high-concentration region 42a, the withstand voltage of the semiconductor device 10 is maintained. Therefore, in the ion implantation performed to form the high-concentration region 42a, the implantation concentration of the p-type dopant may be set relatively high so that the floating region 42 is connected to the body region 36 with low resistance.

On the other hand, a relatively strong electric field may be generated in the low-concentration region 42b due to the depletion through the pn junction with the drift region 34. In the low-concentration region 42b, however, the implantation concentration of the p-type dopant in the ion implantation is low, and hence, the occurrence of crystal defects is suppressed. In other words, in the ion implantation performed to form the low-concentration region 42b, the implantation concentration of the p-type dopant is determined to be within a range where the occurrence of crystal defects is suppressed. Therefore, even if a relatively strong electric field is generated in the low-concentration region 42b, the withstand voltage of the semiconductor device 10 is maintained. When the high-concentration region 42a and the low-concentration region 42b are thus used in combination, the floating region 42 can be connected to the body region 36 with low resistance without inducing occurrence of leakage currents. As a result, the withstand voltage of the semiconductor device 10 is significantly increased.

In view of connecting the floating region 42 to the body region 36 with low resistance, a higher priority is given to the maximum concentration NA of the p-type dopant than to the content SA of the p-type dopant (see FIG. 4) in the high-concentration region 42a. Therefore, the concentration profile of the p-type dopant in the high-concentration region 42a may have a relatively steep peak. On the other hand, in view of sufficiently depleting the drift region 34, a higher priority is given to the content SB of the p-type dopant (see FIG. 4) than to the maximum concentration NB of the p-type dopant in the low-concentration region 42b. Therefore, the concentration profile of the p-type dopant in the low-concentration region 42b may have a relatively flat shape within the range where the occurrence of crystal defects is suppressed. In other words, in the low-concentration region 42b, the concentration of the p-type dopant may be relatively constant in the thickness direction of the SiC substrate 12. For example, in a range of at least 50% of the low-concentration region 42b in the thickness direction, a range of variations in the concentration of the p-type dopant may be at most ±30% with respect to the average of the concentration of the p-type dopant. Based on the foregoing knowledge, in the graph indicating the concentration profile of the p-type dopant in the floating region 42, a bending point or an inflection point may appear on the boundary 42c between the high-concentration region 42a and the low-concentration region 42b, as illustrated in FIG. 4.

The floating region 42 according to the present embodiment is designed such that the ratio of the second distance XB to the first distance XA is two or more. In other words, the condition of XB/XA ≥ 2 is satisfied. This means that the high-concentration region 42a is disposed within a half portion of the floating region 42, which is on the trench 13-side. Hereinafter, a value of XB/XA will be sometimes referred to as a depth ratio X.

In the floating region 42 according to the present embodiment, there is a sufficiently large difference in the concentration of the p-type dopant between the high-concentration region 42a and the low-concentration region 42b. Specifically, the relationship between the maximum concentration NA of the p-type dopant in the high-concentration region 42a and the maximum concentration NB of the p-type dopant in the low-concentration region 42b satisfies the condition of NA/NB ≥ 2.5. In other words, the maximum concentration NB of the p-type dopant in the low-concentration region 42b is at most 40% of the maximum concentration NA of the p-type dopant in the high-concentration region 42a. Hereinafter, a value of NA/NB will be sometimes referred to as a concentration ratio N.

The values of the first distance XA, the second distance XB, the maximum concentration NA in the high-concentration region 42a, and the maximum concentration NB in the low-concentration region 42b are not limited to any specific numerical values. As illustrated in FIG. 5, the parameters XA, XB, NA and NB may be set as appropriate within a range where the depth ratio X satisfies the condition of X = XB/XA ≥ 2 and the concentration ratio N satisfies the condition of N = NA/NB ≥ 2.5 (namely, within a hatched region), depending on other design parameters of the semiconductor device 10. For example, it has been found that, when aluminum is used as the p-type dopant, substantially no crystal defects occur in the SiC substrate 12 on the condition that the implantation concentration of aluminum ions is less than 4 × 10¹⁷/cm³. Therefore, when aluminum is used as the p-type dopant, the maximum concentration NB in the low-concentration region 42b may be less than 4 × 10¹⁷/cm³. Even when another p-type dopant is used, it is presumed that there is an upper limit of the implantation concentration of the p-type dopant, at which substantially no crystal defects occur in the SiC substrate 12. Thus, regardless of the kinds of p-type dopant, the maximum concentration NB in the low-concentration region 42b may be set to a value within a range where substantially no crystal defects occur in the SiC substrate 12.

The concentration profile of the p-type dopant in the floating region 42 may be determined, for example, by the following procedures. First, the second distance XB is determined in consideration of the thickness of the drift region 34 and the ability and the like of an apparatus to be used for ion implantation. Further, the upper limit of the implantation concentration at which substantially no crystal defects occur in the SiC substrate 12 through the p-type dopant ion implantation is determined in advance. The upper limit may be obtained through an experiment or a simulation. Next, the content SB of the p-type dopant in the low-concentration region 42b is determined such that the content SB of the p-type dopant in the low-concentration region 42b is equal to or higher than the content of the n-type dopant in a portion of the drift region 34, which is adjacent to the low-concentration region 42b in the thickness direction. The content of the n-type dopant in the portion of the drift region 34, which is adjacent to the low-concentration region 42b in the thickness direction, may be obtained by, for example, multiplying the concentration of the n-type dopant in the drift region 34 by the thickness of the portion of the drift region 34, which is adjacent to the low-concentration region 42b in the thickness direction (i.e., the distance between the low-concentration region 42b and the drain region 32). Next, a thickness (= XB - XA) of the low-concentration region 42b is determined. In this case, the thickness of the low-concentration region 42b is a thickness that is required to achieve the determined content SB while limiting the maximum concentration NB of the p-type dopant in the low-concentration region 42b to a value equal to or lower than the upper limit of the implantation concentration. In this way, the first distance XA is determined. Finally, the maximum concentration NA required of the high-concentration region 42a is determined such that the floating region 42 is connected to the body region 36 with low resistance. Alternatively, the content SA of the p-type dopant required of the high-concentration region 42a may be determined, and then, the maximum concentration NA in the high-concentration region 42a may be determined based also on the first distance XA.

In the foregoing procedures, the parameters NA, XA and XB may be determined such that the depth ratio X (= XB/XA) satisfies the condition of X ≥ 2, and/or that the concentration ratio N (= NA/NB) satisfies the condition of N ≥2.5.

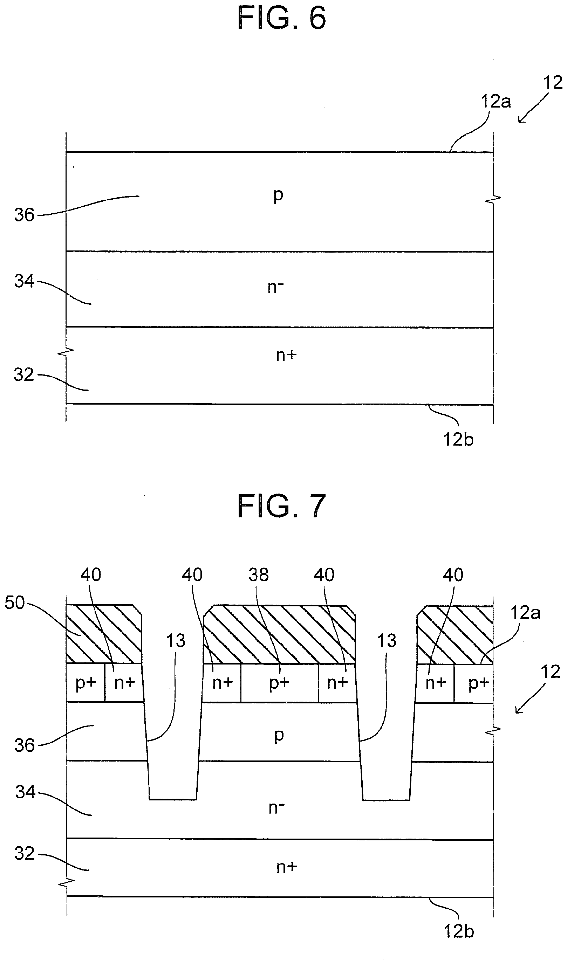

Next, a method of producing the semiconductor device 10 will be described. Note that the production method described below is just one example and does not intend to limit the method of producing the semiconductor device 10. As illustrated in FIG. 6, an n-type SiC wafer to be used as a drain region 32 is prepared, and an n-type drift region 34 is formed on the drain region 32 by epitaxial growth of SiC. Subsequently, a p-type body region 36 is formed on the drift region 34 by epitaxial growth of SiC. Thus, a SiC substrate 12 having a three layer structure including the drain region 32, the drift region 34 and the body region 36 is produced.

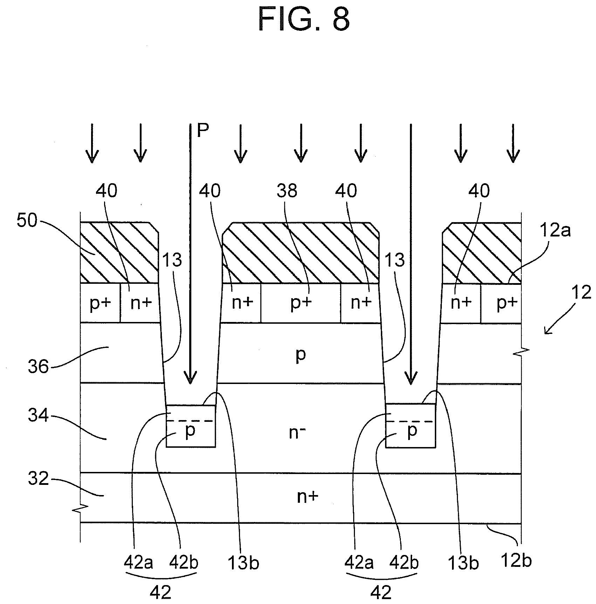

Next, as illustrated in FIG. 7, the ion implantation is performed through an upper surface 12a of the SiC substrate 12, to form p-type contact regions 38 and n-type source regions 40. Then, a mask 50 made of, for example, silicon oxide (SiO₂) is formed on the upper surface 12a of the SiC substrate 12, and trenches 13 are formed in the upper surface 12a of the SiC substrate 12 by dry etching. Next, as illustrated in FIG. 8, while the mask 50 is used as it is, ion implantation of a p-type dopant is performed in each trench 13, to form a floating region 42. A group of arrows P illustrated in FIG. 8 schematically indicates the p-type dopant ion implantation. At this time, a high-concentration region 42a and a low-concentration region 42b are formed by adjusting the ion implantation duration and the implantation intensity (for example, acceleration energy to be imparted to the ions). The n-type dopant and the p-type dopant thus implanted into the SiC substrate 12 are activated by annealing.

Then, gate insulating films 14a, gate electrodes 14, interlayer insulating films 14b, a source electrode 16, and a drain electrode 18 are formed, and the semiconductor device 10 is completed through other necessary processes, such as die cutting.

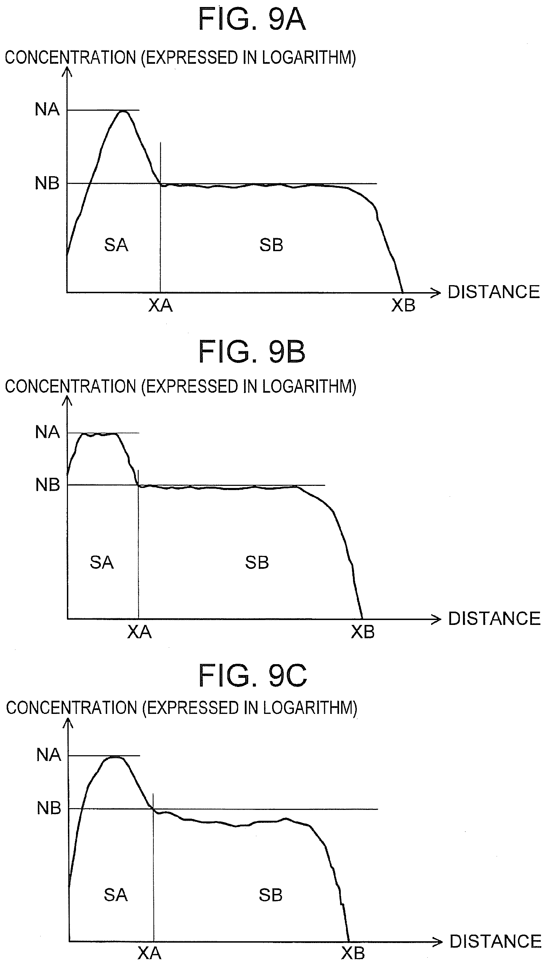

FIG. 9A, FIG. 9B, and FIG. 9C illustrate three specific examples of the concentration profile of the p-type dopant in the floating region 42. In all the specific examples, a bending point or an inflection point appears on the boundary 42c between the high-concentration region 42a and the low-concentration region 42b (namely, at a position apart from the bottom surface 13b of the trench 13 by the first distance XA). Further, in all the specific examples, the condition of XB/XA ≥ 2 and the condition of NA/NB ≥ 2.5 are satisfied. Note that, the ordinate axis of the graph in each of FIG. 9A, FIG. 9B, and FIG. 9C indicates the concentration of the p-type dopant as a logarithm, and therefore the dimensions illustrated in the graph do not always satisfy the condition of XB/XA ≥ 2. As illustrated in FIG. 9A to FIG. 9C, the concentration profile of the p-type dopant in the floating region 42 may be variously changed as long as a bending point or an inflection point appears on the boundary 42c between the high-concentration region 42a and the low-concentration region 42b and the content of the p-type dopant in the low-concentration region 42b is equal to or higher than the content of the n-type dopant in the drift region 34.

While the example embodiments of the invention have been described in detail, the foregoing embodiments are just examples and do not intend to limit the scope of the appended claims. The technical elements described in the specification and the accompanying drawings, individually or in various combinations, provide technical usefulness, and the combinations of the technical elements are not limited to the combinations described in the appended claims at the time of filing of the present application. Further, the techniques described, as examples, in the specification and the accompanying drawings can simultaneously achieve two or more objects, and provide technical usefulness by achieving at least one of these objects.

## Claims

1. A metal-oxide-semiconductor field-effect transistor (10), comprising:
a silicon carbide substrate (12) including a trench (13); and
a gate electrode (14) disposed in the trench (13),
the silicon carbide substrate (12) including:
an n-type source region (40);
an n-type drift region (34);
a p-type body region (36) disposed between the n-type source region (40) and the n-type drift region (34);
a p-type floating region (42) disposed within the drift region (34), the p-type floating region (34) being adjacent to a bottom surface (13b) of the trench (13); and
a p-type connection region (46) extending from the p-type body region (36) to the p-type floating region (42), wherein
the p-type floating region (42) includes a high-concentration region (42a) and a low-concentration region (42b) that are arranged along a thickness direction of the silicon carbide substrate (12),
the high-concentration region (42a) is disposed between the bottom surface (13b) of the trench (13) and the low-concentration region (42b), the high-concentration region (42a) being in contact with the low-concentration region (42b),
when a graph is obtained by plotting a concentration of a p-type dopant in the p-type floating region (42) along the thickness direction, a maximum concentration of the p-type dopant is higher in the high-concentration region (42a) than in the low-concentration region (42b), and the graph has a bending point or an inflection point on a boundary between the high-concentration region (42a) and the low-concentration region (42b), and
a content of the p-type dopant in the low-concentration region (42b) is equal to or higher than a content of an n-type dopant in a portion of the n-type drift region (34), the portion being adjacent to the low-concentration region (42b) in the thickness direction.

2. The metal-oxide-semiconductor field-effect transistor according to claim 1, wherein,
where NA represents the maximum concentration of the p-type dopant in the high-concentration region (42a) and NB represents the maximum concentration of the p-type dopant in the low-concentration region (42b), a condition of NA/NB ≥ 2.5 is satisfied.

3. The metal-oxide-semiconductor field-effect transistor according to claim 1 or 2, wherein:
the boundary between the high-concentration region (42a) and the low-concentration region (42b) is apart, in the thickness direction, from the bottom surface (13b) of the trench (13) by a first distance;
a boundary between the low-concentration region (42b) and the n-type drift region (34) is apart, in the thickness direction, from the bottom surface (13b) of the trench (13) by a second distance; and
where XA represents the first distance and XB represents the second distance, a condition of XB/XA ≥ 2 is satisfied.

4. The metal-oxide-semiconductor field-effect transistor (10) according to claim 1, wherein:
the low-concentration region (42b) includes a flat region and a reduction region that are arranged along the thickness direction of the silicon carbide substrate;
the flat region is a region that is in contact with the high-concentration region (42a), and in which a concentration of the p-type dopant is within a prescribed range with respect to a concentration of the p-type dopant at the bending point or the inflection point; and
the reduction region is a region that is in contact with the n-type drift region (34), and in which the concentration of the p-type dopant decreases in a direction away from the bottom surface (13b) of the trench (13).
